# EUROPEAN PATENT APPLICATION

(11) **EP 4 590 086 A1**
(43) Date of publication of application: **23.07.2025**
(21) Application number: 25150906.3
(22) Date of filing: 09.01.2025
(51) Int. Cl.: H10D 30/67

(54) **SEMICONDUCTOR DEVICE AND METHOD OF MANUFACTURING THE SAME**

(30) Priority: 18.01.2024 KR 20240008289
(71) Applicant: Samsung Electronics Co., Ltd., Suwon-si, Gyeonggi-do 16677 (KR)
(72) Inventor: KIM, Sangwook, 16678 Suwon-si (KR); YANG, Jeeeun, 16678 Suwon-si (KR)
(74) Representative: Elkington and Fife LLP

(57) **Abstract**

Provided are a semiconductor device and a method of manufacturing the semiconductor device. The semiconductor device includes a lower electrode, a channel on the lower electrode and including an oxide semiconductor, an upper electrode on the channel and including tungsten or molybdenum, a first interlayer between the lower electrode and the channel, and a second interlayer between the channel and the upper electrode, wherein the channel has a vertical channel structure extending in a vertical direction from the lower electrode to the upper electrode, and the first interlayer and the second interlayer include different materials.

## Description

### FIELD OF THE INVENTION

The disclosure relates to a semiconductor device with reduced contact resistance and a method of manufacturing the same.

### BACKGROUND OF THE INVENTION

Transistors are semiconductor devices that serve as electrical switches and are used in various integrated circuit (IC) devices including memories, driving ICs, logic devices, etc. In order to increase the degree of integration of IC devices, the space occupied by a transistor therein is rapidly reduced, and research has been conducted to maintain the performance of the IC devices while reducing the size of the transistor.

As semiconductor processes become more refined, transistor sizes decrease, and also the area in which a gate electrode and a channel face each other decreases. Thus, problems are caused due to a short channel effect. For example, phenomena such as threshold voltage variation, carrier velocity saturation, and deterioration of subthreshold characteristics occur. Accordingly, methods of overcoming the short channel effect and effectively reducing the channel length have been sought.

In the case of silicon (Si) channels, as the channel length decreases, problems such as reduced mobility, increased difficulty in controlling a threshold voltage Vₜₕ, increased leakage current, and increased contact resistance occur, which limit the scaling of silicon channels. Accordingly, research into semiconductor devices applying oxide semiconductors to channels has been actively conducted.

### SUMMARY OF THE INVENTION

Provided is a semiconductor device configured to reduce a contact resistance.

Provided is a method of manufacturing a semiconductor device configured to reduce a contact resistance.

Additional aspects will be set forth in part in the description which follows and, in part, will be apparent from the description, or may be learned by practice of the presented embodiments of the disclosure.

According to an aspect of the disclosure, a semiconductor device includes a lower electrode, a channel on the lower electrode and including an oxide semiconductor, an upper electrode on the channel and including tungsten or molybdenum, a first interlayer between the lower electrode and the channel, and a second interlayer between the channel and the upper electrode, wherein the channel has a vertical channel structure extending in a vertical direction from the lower electrode to the upper electrode, the first interlayer and the second interlayer include different materials from each other, the first interlayer includes indium oxide or indium nitride, and the second interlayer includes a material having an oxide forming energy greater than an oxide forming energy of the upper electrode, and the oxide forming energy of the second interlayer is in a range of about -2.5 eV/atom to about 0.5 eV/atom.

The second interlayer may include a material having a work function in a range of about 4.6 eV to about 6.0 eV.

A difference between the oxide forming energy of the second interlayer and the oxide forming energy of the upper electrode may be in a range of about 0.5 eV/atom to about 3.58 eV/atom.

The second interlayer may include at least one of Ni, Co, Rh, Pd, Pt, Re, Ru, and Cu.

The channel may be an oxide including at least one of In, Zn, Ga, Sn, Hf, and Ti.

The lower electrode may include at least one selected from the group consisting of W (tungsten), Co (cobalt), Ni (nickel), Fe (iron), Ti (titanium), Mo (molybdenum), Cr (chromium), Zr (zirconium), Hf (hafnium), Nb (niobium), Ta (tantalum), Ag (silver), Au (gold), AI (aluminum), Cu (copper), Sb (tin), V (vanadium), Ru (ruthenium), Pt (platinum), Zn (zinc), and Mg (magnesium), or a nitride including these materials.

The semiconductor device may further include a bonding layer including TiN between the second interlayer and the upper electrode.

The second interlayer may extend from a bonding surface between the channel and the upper electrode to a side surface of the upper electrode.

The first interlayer may have a thickness in a range of about 1 nm to about 5 nm.

The second interlayer may have a thickness in a range of about 1 nm to about 3 nm.

A thickness of the second interlayer may be less than a thickness of the first interlayer.

The semiconductor device may further include a metal oxide layer between the lower electrode and the first interlayer.

The gate electrode may have a gate all around structure to surround the channel.

The channel, the gate insulating layer, and the gate electrode may be disposed with their longitudinal directions in a vertical direction of the semiconductor device, and may be disposed in a horizontal direction of the semiconductor device.

The channel may have a U-shaped cross section.

The channel may include a first channel having an L-shaped cross-section and a second channel disposed symmetrically to the first channel with respect to a vertical direction of the semiconductor device.

According to another aspect of the disclosure, a method of manufacturing a semiconductor device includes depositing a lower electrode on a substrate, depositing a first interlayer on the lower electrode, depositing a channel including an oxide semiconductor on the first interlayer, depositing a gate insulating layer on the channel, depositing a gate electrode on the gate insulating layer, depositing a second interlayer on an upper surface of the channel, and depositing an upper electrode on the second interlayer, wherein the first interlayer and the second interlayer include different materials from each other, the first interlayer includes indium oxide or indium nitride, and the second interlayer includes a material having an oxide forming energy greater than an oxide forming energy of the upper electrode, and the oxide forming energy of the second interlayer is in a range of about -2.5 eV/atom to about 0.5 eV/atom.

The first interlayer, the channel, and the second interlayer may be formed by an atomic layer deposition (ALD) method.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 schematically illustrates a semiconductor device according to an embodiment;
FIG. 2 illustrates a change in current according to a voltage with respect to a semiconductor device according to an embodiment and a comparative example;
FIG. 3 illustrates a material distribution of a work function and oxide forming energy;
FIG. 4 illustrates a mobility change according to annealing temperature during a thin film process in a plasma enhanced atomic layer deposition (PEALD) process and a sputtering process.
FIG. 5 illustrates an example of changing a second interlayer in the semiconductor device illustrated in FIG. 1;
FIG. 6 illustrates an example of further providing other layers in the semiconductor device illustrated in FIG. 1;
FIG. 7 illustrates a semiconductor device according to an embodiment;
FIG. 8 is a cross-sectional view of a semiconductor device according to an embodiment;
FIG. 9 is a cross-sectional view of a semiconductor device according to an embodiment;
FIG. 10 is a cross-sectional view of a semiconductor device according to an embodiment;
FIG. 11 is a cross-sectional view of a semiconductor device according to an embodiment;
FIG. 12 is a flowchart illustrating a method of manufacturing a semiconductor device according to an embodiment;
FIG. 13 is a diagram illustrating an ALD method used in a method of manufacturing a semiconductor device according to an embodiment;
FIGS. 14 to 29 are diagrams illustrating a method of manufacturing a semiconductor device according to an embodiment;
FIG. 30 illustrates a memory device including a semiconductor device according to an embodiment;
FIG. 31 is a schematic block diagram of a display driver integrated circuit (IC) (DDI) including a semiconductor device and a display device including the DDI according to an embodiment;
FIG. 32 is a circuit diagram of a CMOS inverter including a semiconductor device according to an embodiment;
FIG. 33 is a circuit diagram of a CMOS SRAM device including a semiconductor device according to an embodiment;
FIG. 34 is a circuit diagram of a CMOS NAND circuit including a semiconductor device according to an embodiment;
FIG. 35 is a block diagram of an electronic system including a semiconductor device according to an embodiment; and
FIG. 36 is a block diagram of an electronic system including a semiconductor device according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a semiconductor device and a method of manufacturing the same according to various embodiments are described in detail with reference to the accompanying drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" an element, another element may be further included, rather than excluding the existence of the other element, unless otherwise described. Sizes or thicknesses of components in the drawings may be arbitrarily exaggerated for convenience of explanation. Further, when a certain material layer is described as being disposed on a substrate or another layer, the material layer may be in contact with the other layer, or there may be a third layer between the material layer and the other layer. In the following embodiments, materials constituting each layer are provided merely as an example, and other materials may also be used.

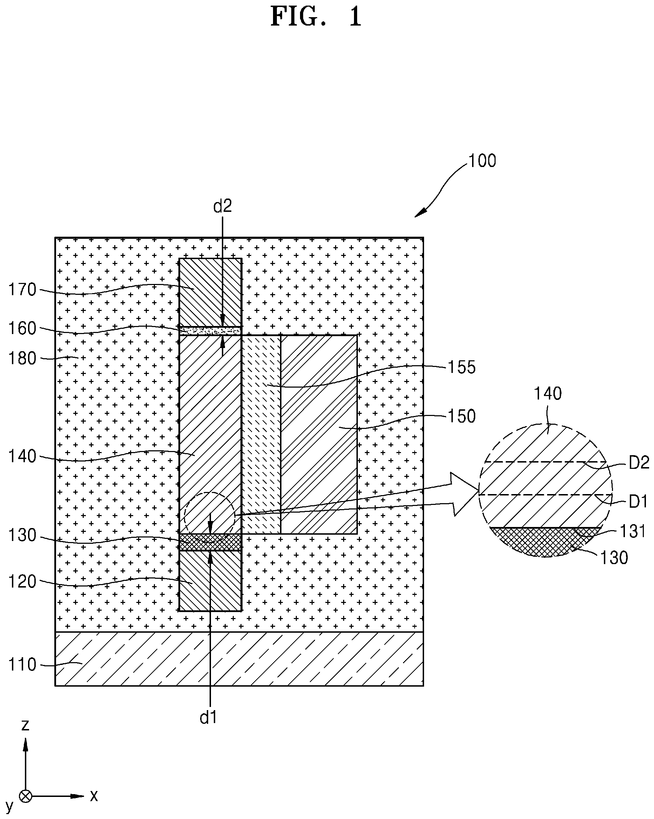

FIG. 1 schematically illustrates a semiconductor device 100 according to an embodiment.

Referring to FIG. 1, the semiconductor device 100 may include a substrate 110, a lower electrode 120 provided on the substrate 110, a channel 140 provided on the lower electrode 120, and an upper electrode 170 provided on the channel 140. A first interlayer 130 may be provided between the lower electrode 120 and the channel 140, and a second interlayer 160 may be provided between the channel 140 and the upper electrode 170. A gate electrode 150 may be provided on one side of the channel 140, and a gate insulating layer 155 may be provided between the channel 140 and the gate electrode 150.

The lower electrode 120, the channel 140, and the upper electrode 170 may be disposed in a direction (z direction) perpendicular to the substrate 110. The lower electrode 120, the channel 140, and the upper electrode 170 may have the same width. However, the disclosure is not limited thereto. The lower electrode 120 may be a source electrode and the upper electrode 170 may be a drain electrode, or the lower electrode 120 may be a drain electrode and the upper electrode 170 may be a source electrode.

The gate electrode 150 may be disposed with its longitudinal direction (z direction) perpendicular to the substrate 110. Herein, the longitudinal direction indicates a direction in which the length of the corresponding component is relatively long when viewed from the drawing. The channel 140, the gate insulating layer 155, and the gate electrode 150 may be arranged in a line in a horizontal direction (x direction) with respect to the substrate 110.

A mold insulating layer 180 may be provided on the substrate 110 to fill an empty space. The lower electrode 120 may be spaced apart from the substrate 110 by the mold insulating layer 180.

The substrate 110 may be an insulating substrate or may be a semiconductor substrate having an insulating layer formed on a surface thereof. Alternatively, the substrate 110 may be a semiconductor substrate. The semiconductor substrate may include, for example, Si, Ge, SiGe, or a group III-V semiconductor material. The substrate 110 may be, for example, a silicon substrate having a silicon oxide formed on the surface thereof, but is not limited thereto.

The lower electrode 120 may be spaced apart from the substrate 110. The lower electrode 120 may include at least one selected from the group consisting of W (tungsten), Co (cobalt), Ni (nickel), Fe (iron), Ti (titanium), Mo (molybdenum), Cr (chromium), Zr (zirconium), Hf (hafnium), Nb (niobium), Ta (tantalum), Ag (silver), Au (gold), Al (aluminum), Cu (copper), Sb (tin), V (vanadium), Ru (ruthenium), Pt (platinum), Zn (zinc), and Mg (magnesium), or a nitride including these materials. For example, the lower electrode 120 may include Ti, TiN, Ta, TaN, Mo, Ru, W, WN, TiSiN, or WSiN.

FIG. 1 illustrates an example in which the lower electrode 120 includes one layer, but the disclosure is not limited thereto, and the lower electrode 120 may have a multiple layer structure. For example, the lower electrode 120 may include a first electrode, a second electrode below the first electrode, and a third electrode below the second electrode. The first electrode may include at least one selected from the group including W (tungsten), Co (cobalt), Ni (nickel), Fe (iron), Ti (titanium), Mo (molybdenum), Cr (chromium), Zr (zirconium), Hf (hafnium), Nb (niobium), Ta (tantalum), Ag (silver), Au (gold), AI (aluminum), Cu (copper), Sb (tin), V (vanadium), Ru (ruthenium), Pt (platinum), Zn (zinc), and Mg (magnesium), or a nitride including these materials. The second electrode may include WSi, and the third electrode may include TiN.

As another example, the lower electrode 120 may include Zn having a content of 10 at% or less. Zn may have a content of 10 at% or less with respect to the total metal elements in the lower electrode 120. Here, the content of Zn may represent the content of Zn with respect to the total metal elements included in the lower electrode 120 excluding oxygen. Alternatively, the lower electrode 120 may include Zn having a content of 5 at% or less.

The channel 140 may be between the lower electrode 120 and the upper electrode 170, and may extend long in the direction (z direction) perpendicular to the substrate 110. That is, the semiconductor device 100 may have a vertical channel structure in which the channel 140 extends long from the lower electrode 120 toward the upper electrode 170. The channel 140 may include an oxide semiconductor. The channel 140 may be an oxide including at least one of In, Zn, Ga, Sn, Hf, and Ti. The channel 140 may include, for example, InGaZnO, InGaO, InSnO, InZnO, InO, InHfO, InTiO, HflnZnO, or any combination thereof. The channel 140 may have an amorphous state, and accordingly, off-current may be reduced.

The channel 140 may include, for example, In and Zn, and the content of In of the channel 140 may be greater than or equal to the content of Zn of the channel 140. The channel 140 may include (In)ₐ₁(Zn)ₐ₂(M)ₐ₃O. Here, M may be Sn, Ga, Hf, Ti, or any combination thereof, a1 may be a real number satisfying 0<a1≤10, a2 may be a real number satisfying 0<a2≤10, a3 may be a real number satisfying 0≤a3≤10, and a1>a2.

The upper electrode 170 may include tungsten (W) or molybdenum (Mo).

The first interlayer 130 may be provided between the lower electrode 120 and the channel 140 to reduce contact resistance of the lower electrode 140. When the channel 140 is formed on the lower electrode 120, the channel 140 may be formed by an atomic layer deposition process. During the atomic layer deposition process, because a strong oxidizing agent such as Os is used for the oxidation reaction of a precursor, the contact resistance degrades due to the reaction with the oxidizing agent. The first interlayer 130 may include indium oxide (InO) or indium nitride (InN) to reduce contact resistance of the lower electrode 120. For example, the first interlayer 130 may include at least one of InGaZnO, InGaO, InSnO, InZnO, InO, and InN. For example, when the first interlayer 130 includes InGaZnO or InZnO, the content of In may be greater than the content of Zn.

In the above examples, when the first interlayer 130 is an oxide including a first indium and the channel 140 is an oxide including a second indium, the content of first indium in the first interlayer 130 may be greater than the content of the second indium in the channel 140. The content of the second indium of the channel 140 may be greater in a region relatively close to the first interlayer 130 than in a region relatively far from the first interlayer 130. Referring to FIG. 1, the content of the second indium at a D1 position of the channel 140 is greater than the content of the second indium at a D2 position, and D1 and D2 are respectively located at a D1 distance and a D2 distance from a boundary surface 131 between the first interlayer 130 and the channel 140, and D1<D2. Alternatively, the content of the second indium of the channel 140 may have a gradation content distribution that gradually increases toward the first interlayer 130.

For example, the first interlayer 130 may include (In)_{b1}(M¹)_{b2}O, and the channel 140 may include (In)_{c1}(M²)_{c2}O. Here, M¹ and M² may be Zn, Sn, Ga, Hf, Ti, or any combination thereof, b1 may be a real number satisfying 0<b1≤10, b2 may be a real number satisfying 0<b2≤10, c1 may be a real number satisfying 0<c1≤10, c2 may be a real number satisfying 0<c2≤10, and b1>c1.

For example, when each of the channel 140 and the first interlayer 130 includes In, Ga, Zn, and O, the composition ratio of In, Ga, and Zn of the channel 140 may be 1:1:1, and the composition ratio of In, Ga, and Zn of the first interlayer 130 may be 2:1:1.

The first interlayer 130 may be disposed to be in direct contact with the channel 140.

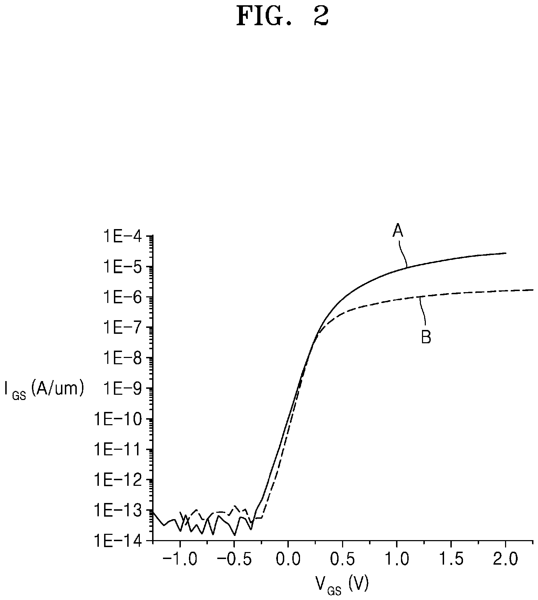

FIG. 2 is a graph illustrating a current according to a voltage with respect to an embodiment A including an InN interlayer between a W lower electrode and an IGZO channel and a comparative example B having no interlayer between the W lower electrode and the IGZO channel. The current is relatively higher in graph A than in graph B, which may confirm that a contact resistance is lower in graph A than in graph B.

The second interlayer 160 may include a material having an oxide forming energy greater than an oxide forming energy of the upper electrode 170 to suppress the supply of oxygen to the channel 140. Because the second interlayer 160 is formed in an oxygen-free atmosphere, a thickness d2 of the second interlayer 160 is less than a thickness d1 of the first interlayer 130. The contact resistance may be reduced by making the thickness d2 of the second interlayer 160 relatively less than the thickness d1 of the first interlayer 130. The thickness d1 of the first interlayer 130 may be in the range of about 1 nm to about 5 nm. The thickness d2 of the second interlayer 160 may be in the range of about 1 nm to about 3 nm.

Meanwhile, the second interlayer 160 may be oxidized in a subsequent heat treatment process to degrade the contact resistance. Therefore, the second interlayer 160 includes the material having the oxide forming energy greater than the oxide forming energy of the upper electrode 170 to suppress oxygen in the subsequent heat treatment process, thereby preventing the contact resistance from increasing. The second interlayer 160 may be disposed to be in direct contact with the channel 140.

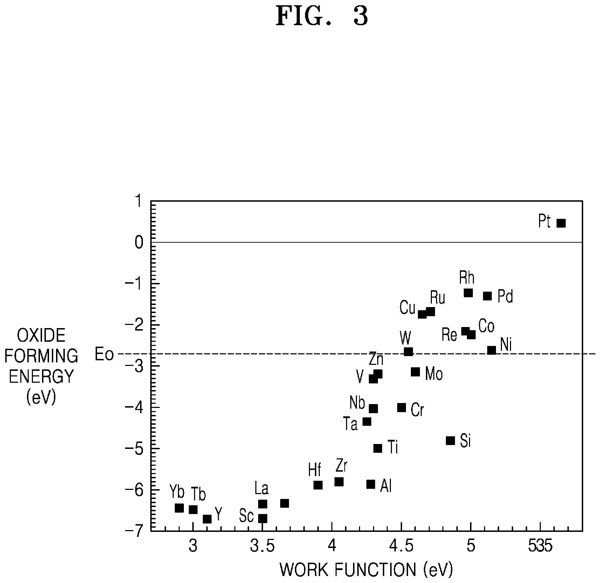

FIG. 3 illustrates a material distribution of a work function and oxide forming energy. The second interlayer 160 may include a material having the oxide forming energy greater than the oxide forming energy of the upper electrode 170. The upper electrode 170 may include tungsten (W) or molybdenum (Mo), and the second interlayer 160 may include the material having the oxide forming energy greater than an oxide forming energy of tungsten (W) or molybdenum (Mo). An oxide forming energy Eo of tungsten is higher than that of molybdenum, and is approximately -2.65 eV/atom._The second interlayer 160 may include, for example, the material having the oxide forming energy greater than -2.65 eV/atom. The second interlayer 160 may include the material having the oxide forming energy in the range of about -2.5 eV/atom to about 0.5 eV/atom. A difference between the oxide forming energy of the second interlayer 160 and the oxide forming energy of the upper electrode 170 may be in the range of about 0.5 eV/atom to about 3.58 eV/atom.

The second interlayer 160 may include at least one of Ni, Co, Rh, Pd, Pt, Re, Ru, and Cu.

The second interlayer 160 may include a material having a work function greater than 4.56 eV. For example, the second interlayer 160 may include a material having a work function in the range of about 4.6 eV to about 6.0 eV.

In the semiconductor device 100 according to an embodiment, the degradation of contact resistance may be minimized by configuring the materials of the first interlayer 130 and the second interlayer 160 differently. That is, the first interlayer 130 may include a material suitable for reducing the contact resistance at an interface between the lower electrode 120 and the channel 140, and the second interlayer 160 may include a material suitable for reducing the contact resistance at an interface between the channel 140 and the upper electrode 170. The second interlayer 160 does not include a material included in the first interlayer 130, and the first interlayer 130 does not include a material included in the second interlayer 160.

Configuring the materials of the first interlayer 130 and the second interlayer 160 differently is described in more detail.

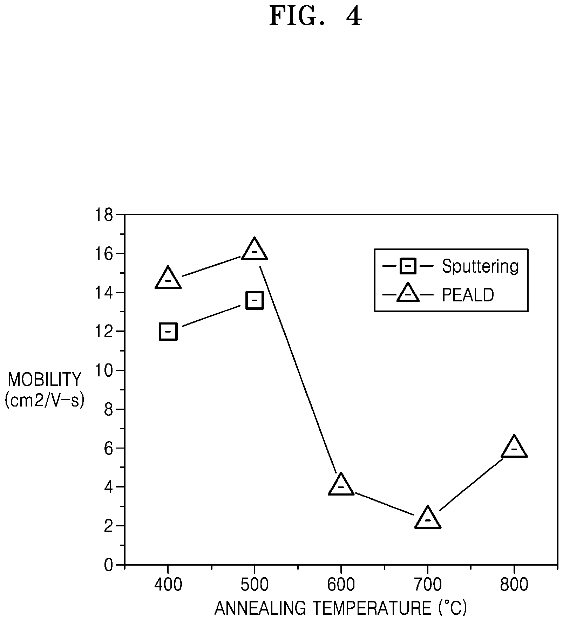

FIG. 4 illustrates a mobility change according to annealing temperature. When a semiconductor device is deposited by a plasma-enhanced atomic layer deposition (PEALD) process, mobility decreases as the annealing temperature increases. As the annealing temperature increases, each layer of a semiconductor device is crystallized, and mobility decreases according to crystallization, which indicates that resistance increases. That is, the crystallization of each layer of the semiconductor device may be a factor that increases resistance. Therefore, lowering the crystallization of the semiconductor device is good for lowering resistance.

However, when the second interlayer 160 includes indium, the crystallization temperature of the channel 140 may be reduced as the content of indium increases. When the first interlayer 130 between the lower electrode 120 and the channel 140 includes indium, because the channel 140 is deposited on the first interlayer 130, the first interlayer 130 or the lower electrode 120 is less affected by the crystallization of the channel 140. On the other hand, when the second interlayer 160 includes indium, because the second interlayer 160 is deposited on the channel 140, a contact region acts as a seed according to the crystallization of the channel 140 to increase the crystallinity of the upper electrode 170, thereby increasing the resistance. In addition, because the degree of crystallization of a contact part of the upper electrode 170 may vary depending on a temperature or a subsequent process, the uniformity of a memory cell array including the semiconductor device may degrade. Therefore, while the first interlayer 130 includes indium, the second interlayer 130 may be configured not to include indium.

Next, the reason why it is difficult to apply a material applied to the second interlayer 160 to the first interlayer 130 is that is difficult to dry etch a material having a high oxide forming energy, which makes it difficult to form an interlayer having the high oxide forming energy on the lower electrode 120.

As described above, in the semiconductor device 100 according to an embodiment, the first interlayer 130 and the second interlayer 160 include different materials from each other, and thus, the contact resistance of the lower electrode 120 and the upper electrode 170 may be reduced.

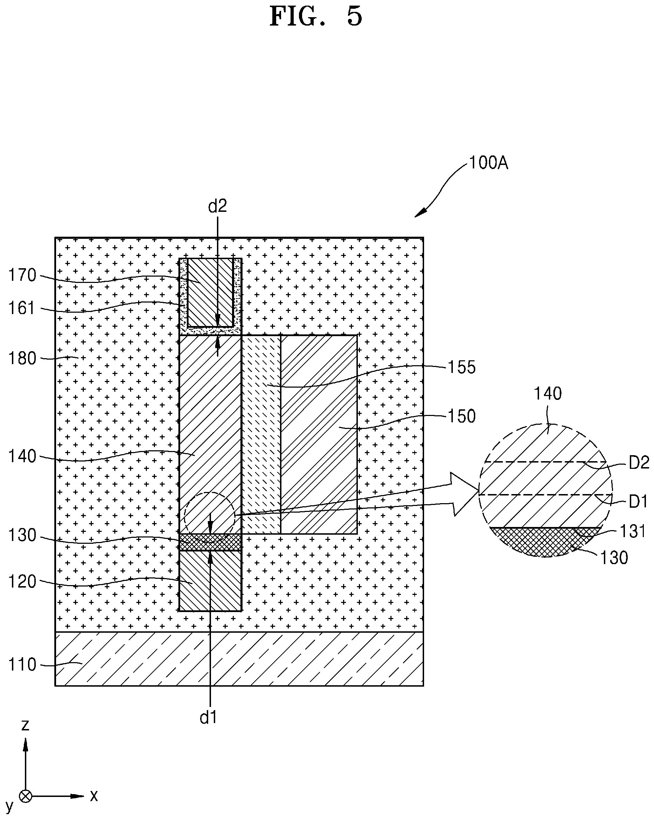

FIG. 5 illustrates an example of changing a second interlayer in a semiconductor device illustrated in FIG. 1. In FIG. 5, components using the same reference numerals as in FIG. 1 have the same configurations and effects, and thus, detailed descriptions thereof are omitted.

The semiconductor device 100A may include the second interlayer 161 between the channel 140 and the upper electrode 170. The second interlayer 161 may extend from a bonding surface between the channel 140 and the upper electrode 170 to a side surface of the upper electrode 170. The second interlayer 161 may also be provided at an interface between the upper electrode 170 and the mold insulating layer 180 to further reduce the contact resistance of the upper electrode 170.

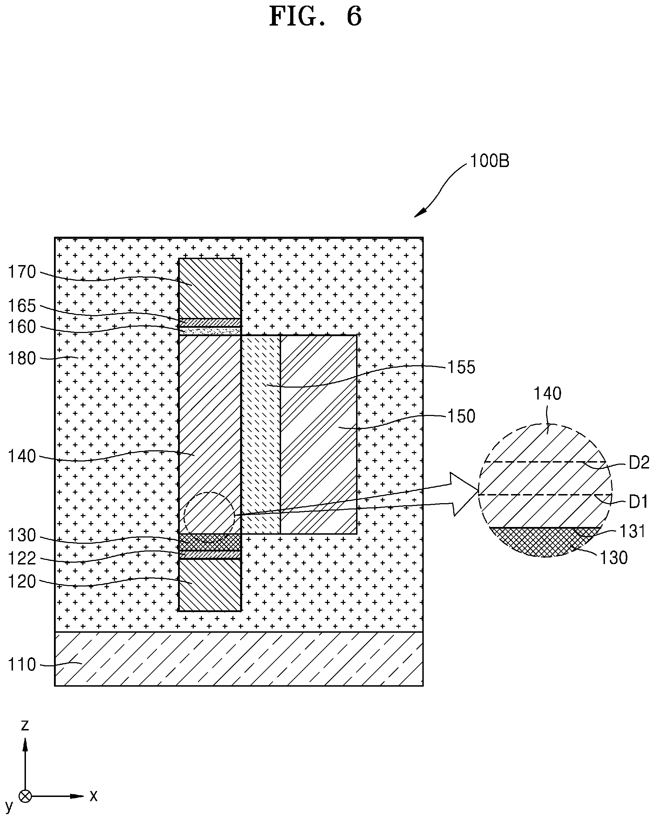

FIG. 6 illustrates an example of further providing some layers in a semiconductor device illustrated in FIG. 1.

The semiconductor device 100B may include a metal oxide layer 122 between the lower electrode 120 and the first interlayer 130. The semiconductor device 100B may include a bonding layer 165 between the second interlayer 160 and the upper electrode 170. The bonding layer 165 may include, for example, TiN.

The metal oxide layer 122 may be an oxide including the same metal as a metal included in the lower electrode 120. For example, the metal oxide layer 122 may be an oxide layer including W (tungsten), Co (cobalt), Ni (nickel), Fe (iron), Ti (titanium), Mo (molybdenum), Cr (chromium), Zr (zirconium), Hf (hafnium), Nb (niobium), Ta (tantalum), Ag (silver), Au (gold), AI (aluminum), Cu (copper), Sb (tin), V (vanadium), Ru (ruthenium), Pt (platinum), Zn (zinc), and Mg (magnesium), or any combination thereof.

The content of oxygen included in the metal oxide layer 122 may change from the lower electrode 120 to the channel 140. For example, the content of oxygen included in the metal oxide layer 122 may increase toward the channel 140.

The metal oxide layer 122 may be formed by reacting a metal source with an oxygen source on the lower electrode 120, or may be formed by oxidizing a metal of the lower electrode 120 by heat treatment in a process of forming the channel 140 or manufacturing the semiconductor device 100B.

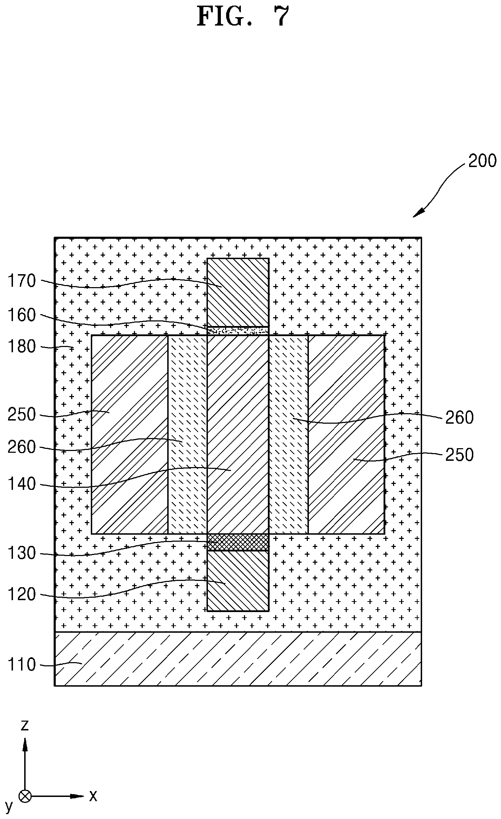

FIG. 7 illustrates a semiconductor device 200 of another example. In FIG. 7, components using the same reference numbers as in FIG. 1 have substantially the same configurations and effects as those described with reference to FIG. 1, and thus detailed descriptions thereof are omitted.

The semiconductor device 200 includes the lower electrode 120, the first interlayer 130, the channel 140, the second interlayer 160, and the upper electrode 170 arranged in a direction (z direction) perpendicular to the substrate 110. A gate insulating layer 260 may be provided around the channel 140, and a gate electrode 250 may be provided around the gate insulating layer 260. The gate electrode 250 is provided around the channel 140 to increase an area where the gate electrode 250 and the channel 140 face each other, and improve a short channel effect. The semiconductor device 200 may be applied to a so-called gate all around structure. Although not shown in FIG. 7, the metal oxide layer 122 and the bonding layer 165 described with reference to FIG. 6 may also be applied to FIG. 7.

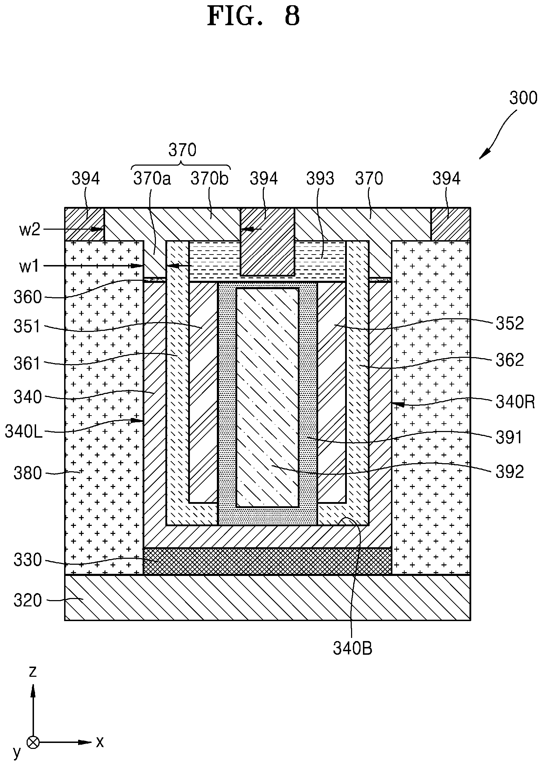

FIG. 8 illustrates a semiconductor device 300 according to another embodiment.

The semiconductor device 300 may include a lower electrode 320, a first interlayer 330 provided on the lower electrode 320, and a channel 340 provided on the first interlayer 330.

The channel 340 may have a U-shaped cross-section. The channel 340 may include a bottom portion 340B in contact with the first interlayer 330, a first vertical extension portion 340L extending in a direction (z direction) perpendicular to the lower electrode 320 from one end of the bottom portion 340B, and a second vertical extension portion 340R extending in the direction (z direction) perpendicular to the lower electrode 320 from the other end of the bottom portion 340B.

A first gate electrode 351 may be spaced apart from the first vertical extension portion 340L, and a second gate electrode 352 may be spaced apart from the second vertical extension portion 340R. A first gate insulating layer 361 may be provided between the first vertical extension portion 340L and the first gate electrode 351, and a second gate insulating layer 362 may be provided between the second vertical extension portion 340R and the second gate electrode 352.

The first gate electrode 351 and/or the second gate electrode 352 may extend in a second horizontal direction y. The first gate electrode 351 and the second gate electrode 352 may be spaced apart from each other. The first gate electrode 351 and/or the second gate electrode 352 may constitute a word line. An electrical signal input to the first gate electrode 351 may not match an electrical signal input to the second gate electrode 352. The first gate electrode 351 may control a channel of the first vertical extension portion 340L, and the second gate electrode 352 may control a channel of the second vertical extension portion 340R.

An insulating liner 391 may be disposed between the first gate electrode 351 and the second gate electrode 352, which are spaced apart from each other. The insulating liner 391 may be conformally disposed on sidewalls of the first gate electrode 351 and the second gate electrode 352 facing each other, and/or an upper surface of the channel 340. The insulating liner 391 may have an upper surface disposed on the same plane as the first gate electrode 351 and the second gate electrode 352. The insulating liner 391 may include, for example, silicon nitride. A buried insulating layer 392 may fill a space between the first gate electrode 351 and the second gate electrode 352 spaced apart from each other on the insulating liner 391. The buried insulating layer 392 may include, for example, silicon oxide. An upper insulating layer 393 may be disposed on an upper surfaces of the first gate electrode 351, the second gate electrode 352, and/or the buried insulating layer 392. An upper surface of the upper insulating layer 393 may be disposed at the same level as an upper surface of a mold insulating layer 380.

The upper electrode 370 may be disposed on an upper portion of the channel 340. The upper electrode 370 may serve as a landing pad. The upper electrode 370 may include an upper left electrode and an upper right electrode. The upper left electrode may be electrically connected to the first vertical extension portion 340L. The upper right electrode may be electrically connected to the second vertical extension portion 340R. The upper left electrode and the upper right electrode may not be electrically connected to each other. The upper electrode 370 may include a lower portion 370a and an upper portion 370b, which have different widths from each other. The upper portion 370b of the upper electrode 370 may be a land pad of the upper electrode 370 disposed at a higher level than that of an upper surface of the mold insulating layer 380. The lower portion 370a of the upper electrode 370 may be a buried contact of the upper electrode 370 disposed inside an upper electrode recess defined between the mold insulating layer 380 and the upper insulating layer 393. In an embodiment, the lower portion 370a of the upper electrode 370 may have a first width w1 in a first horizontal direction x, and the upper portion 370b of the upper electrode 370 may have a second width w2 greater than the first width w1 in the first horizontal direction x. The lower portion 370a of the upper electrode 370 may have a bottom surface disposed inside the upper electrode recess, and the upper portion 370b of the upper electrode 370 is on the upper surface of the mold insulating layer 380 and the upper surface of the upper insulating layer 393 on the lower portion 370a of the upper electrode 370, and accordingly, the upper electrode 370 may have a T-shaped vertical cross-section. A second interlayer 360 may be provided between the bottom surface of the lower portion 370a of the upper electrode 370 and the first vertical extension portion 340L and between the bottom surface of the lower portion 370a of the upper electrode 370 and the second vertical extension portion 340R.

Both sidewalls of the lower portion 370a of the upper electrode 370 may be aligned with both sidewalls of the first vertical extension portion 340L and the second vertical extension portion 340R. The bottom surface of the lower portion 370a of the upper electrode 370 may be disposed at a level equal to or higher than an upper surface of the first gate electrode 351 and/or the second gate electrode 352, and a part of the sidewall of the lower portion 370a of the upper electrode 370 may be covered by the first gate insulating layer 361 and/or the second gate insulating layer 362. An upper electrode insulating layer 394 surrounding the upper electrode 370 may be disposed on the upper surfaces of the mold insulating layer 380 and the upper insulating layer 393. The semiconductor device 300 may have a vertical channel transistor (VCT) structure including a vertical channel region extending in the direction z perpendicular to the lower electrode 320. The first gate electrode 351 and the second gate electrode 352 may have a straight cross-section, the first gate insulating layer 361 may have an L-shaped cross-section, and the second gate insulating layer 362 may have a cross-section symmetrical to the first gate insulating layer 361 with respect to a z-axis. Alternatively, the first gate insulating layer 361 and the second gate insulating layer 362 may have a straight cross-section, like the first gate electrode 351 and the second gate electrode 352.

In the semiconductor device 300, the first interlayer 330 may be provided between the lower electrode 320 and the bottom portion 340B of the channel 340. The second interlayer 360 may be provided between the first vertical extension portion 340L of the channel 340 and the lower portion 370a of the upper electrode 370 and between the second vertical extension portion 340R of the channel 340 and the lower portion 370a of the upper electrode 370.

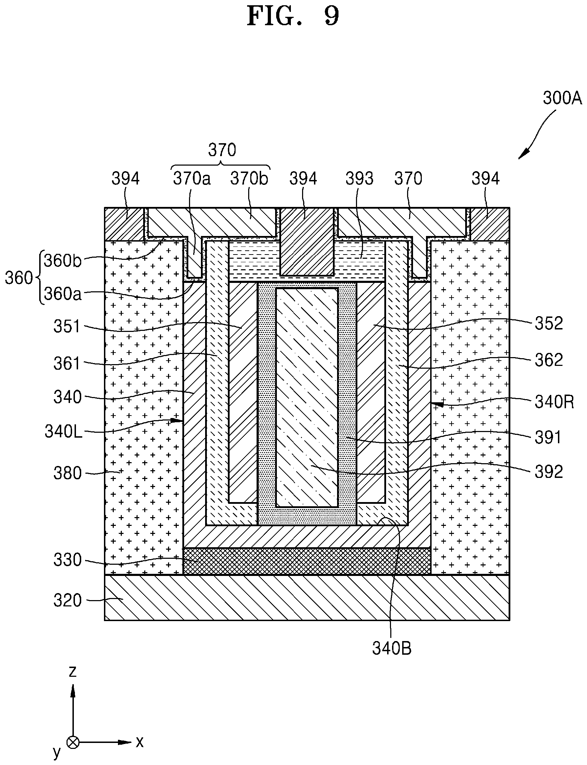

FIG. 9 illustrates an example in which a position of the second interlayer is changed as compared with FIG. 8. In order to avoid redundancy of the description, only the second interlayer 360 is described with reference to FIG. 9. In a semiconductor device 300A, the second interlayer 360 may include a lower interlayer 360a at an interface between the first vertical extension portion 340L of the channel 340 and the lower portion 370a of the upper electrode 370 and a side interlayer 360b provided on a side surface of the upper electrode 370 and on a portion of a bottom surface of the upper portion 370b of the upper electrode 370. In addition, the second interlayer 360 may include the lower interlayer 360a at an interface between the second vertical extension portion 340R and the lower portion 370a of the other upper electrode 370 and a side interlayer 360b provided on the side surface of the other upper electrode 370 and on a portion of a bottom surface of the upper portion 370b of the other upper electrode 370. The second interlayer 360 extends to the side surface of the upper electrode 370, and thus, contact resistance may be further reduced.

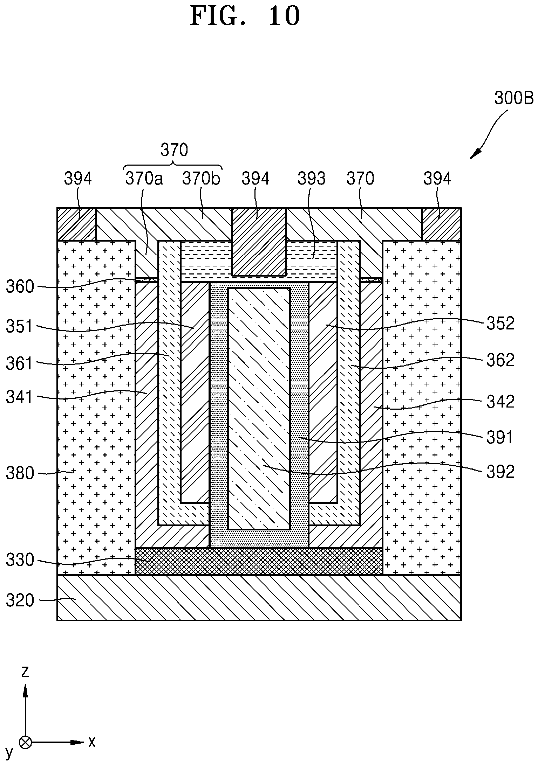

FIG. 10 illustrates a semiconductor device 300B according to another embodiment.

In FIG. 10, components using the same reference numerals as in FIG. 8 have substantially the same configurations and effects, and thus detailed descriptions thereof are omitted.

In FIG. 10, compared with FIG. 8, shapes of channels in the semiconductor device 300B may be different. The channels may include a first channel 341 and a second channel 342. The first channel 341 may have an L-shaped cross-section, and the second channel 342 may have a shape symmetrical to the first channel 341 with respect to the z direction. The first channel 341 and the second channel 342 are separated from each other.

The first channel 341 and the second channel 342 may be located such that their longitudinal directions are arranged in a direction (z direction) perpendicular to a substrate (not shown).

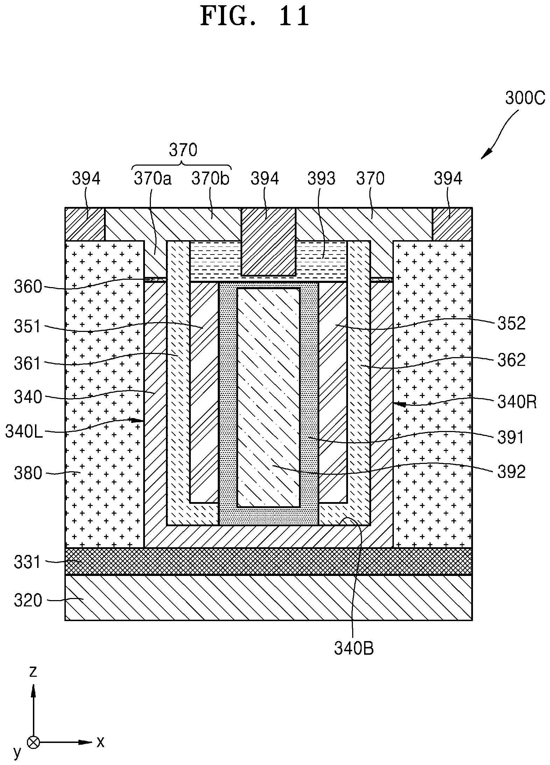

FIG. 11 illustrates an example in which a first interlayer is changed in a semiconductor device illustrated in FIG. 8.

As compared with FIG. 8, in FIG. 11, the first interlayer 331 may be provided over the entire lower electrode 320 in the semiconductor device 300C. Here, the lower electrode 320 may include a bit line, and the first interlayer 331 may be provided along the lower electrode 320. The first interlayer 331 may be longer than the bottom portion 340B of the channel 340.

Next, the effects of the semiconductor devices 100, 200, 300, 300A, 300B, and 300C according to an embodiment are described.

The semiconductor devices 100, 200, 300, 300A, 300B, and 300C may be applied to transistors including the oxide semiconductor channel 140. Referring to FIG. 9, the first interlayer 330 may be provided to increase the content of In between the lower electrode 320 and the channel 340 so that the contact resistance may be lowered. For example, W, which is widely used as an electrode material, has a strong oxidation reactivity, is easily oxidized during the oxidation reaction of an ALD precursor, and at the same time, suppresses an oxidation reaction of In on an electrode surface, thereby lowering the composition of In of an oxide semiconductor. When the composition of In is lowered in the channel 340, device characteristics may degrade such as a carrier decreases, the resistance increases, and an on current Iₒₙ decreases.

Therefore, the contact resistance of the lower electrode 320 may be reduced by providing the first interlayer 330 including indium between the channel 340 and the lower electrode 320.

As silicon-based memory or logic device reaches a high integration limit and requires a channel length in tens or several nanometers, and thus, reducing off-current is significantly important. In addition, it is necessary to improve subthreshold swing (SS) and on/off ratio as characteristics required to clarify the distinction between on/off states. However, a silicon-based semiconductor device has a limitation in improving such characteristics. On the other hand, a semiconductor device employing the oxide semiconductor in a channel is very excellent in the required characteristics (low off-current, low SS, and high on/off ratio). Therefore, the degree of integration may be increased by applying the oxide semiconductor device with such advantages to a memory or logic device, or stacking the oxide semiconductor device on a Si-based device through a low-temperature process of 500 °C or less.

In addition, the contact resistance of the upper electrode 370 may be reduced by providing the second interlayer 370 including a material having a greater oxide forming energy than that of the upper electrode 360 between an upper surface of the channel 340 and the upper electrode 370.

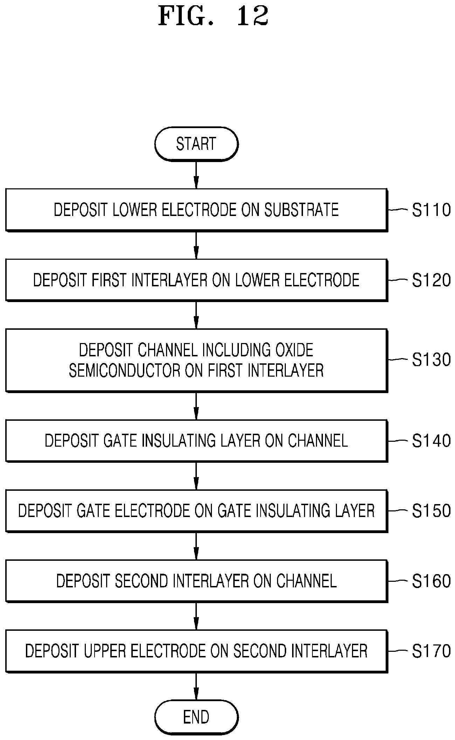

FIG. 12 is a flowchart illustrating a method of manufacturing a semiconductor device according to an embodiment.

A lower electrode is deposited on the substrate (S110), and a first interlayer is deposited on the lower electrode (S120). A channel including an oxide semiconductor is deposited on the first interlayer (S130). The first interlayer and the channel may be deposited using, for example, an ALD process or a PE-ALD process. A gate insulating layer is deposited on the channel (S140). Then, a gate electrode is deposited on the gate insulating layer (S150). A second interlayer is deposited on the channel (S160), and an upper electrode is deposited on the second interlayer (S170).

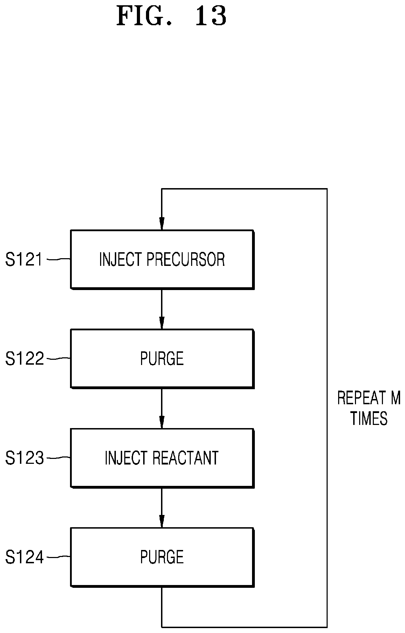

FIG. 13 is a flowchart illustrating a process of depositing a first interlayer, a channel, and a second interlayer. An operation of depositing the first interlayer, the channel, and the second interlayer may include an ALD process. The ALD process may include operation S121 of injecting a precursor into a chamber, purge operation S122, operation S123 of injecting a reactant into the chamber to react with the precursor, and purge operation S124. Operations S121, S122, S123, and S124 may be repeated m times (m is a natural number), for example, 1 to 100 times. Alternatively, m may include a range of 1 to 70 times.

The ALD process may be performed by a difference in the initial crystal nucleation rate of a thin film according to chemical species selectively exposed on a surface of a lower electrode. The first interlayer having a high content of indium may be selectively deposited only on an electrode by applying a precursor having a high reactivity with an electrode material to the lower electrode. The content of indium in the first interlayer may be increased by increasing a subcycle of initial deposition of the thin film when a precursor having a low reactivity with the electrode material is used in the lower electrode. The type of precursor is a material such as 3-Dimethylaminopropyl)dimethylindium (DADI) including In, and this material does not have a high surface reactivity with the lower electrode such as W, Pt, and Au, and thus the content of In tends to decrease rapidly at an interface. Therefore, it is necessary to increase the subcycle of the precursor on the lower electrode.

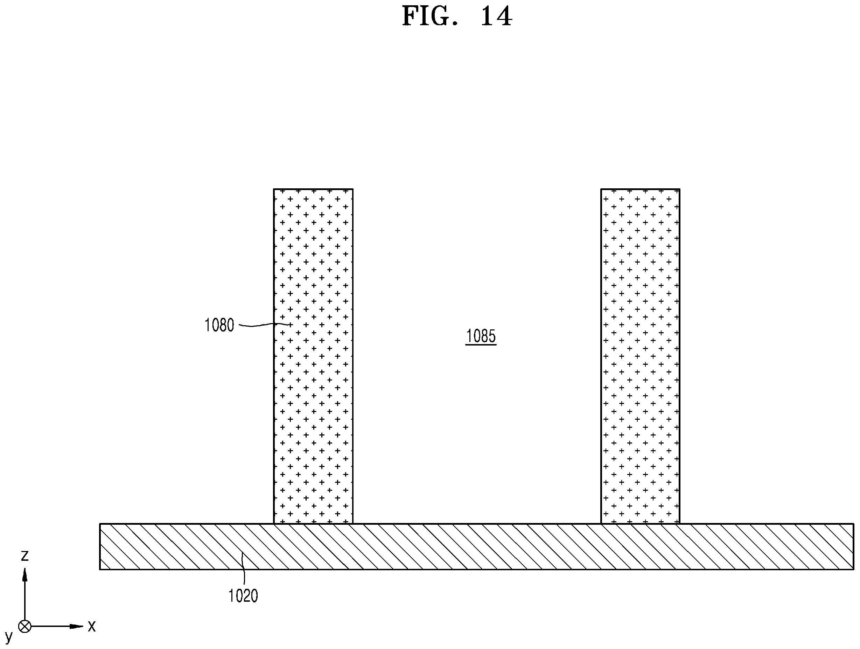

Next, a method of manufacturing a semiconductor device according to an embodiment is described with reference to FIGS. 14 to 29.

Referring to FIG. 14, a plurality of mold insulating layers 1080 extending in the second horizontal direction y may be deposited on a lower electrode 1020 extending in the first horizontal direction x. The mold insulating layer 1080 may be stacked to a certain height in the vertical direction z. The plurality of mold insulating layers 1080 and the lower electrode 1020 may form an opening 1085.

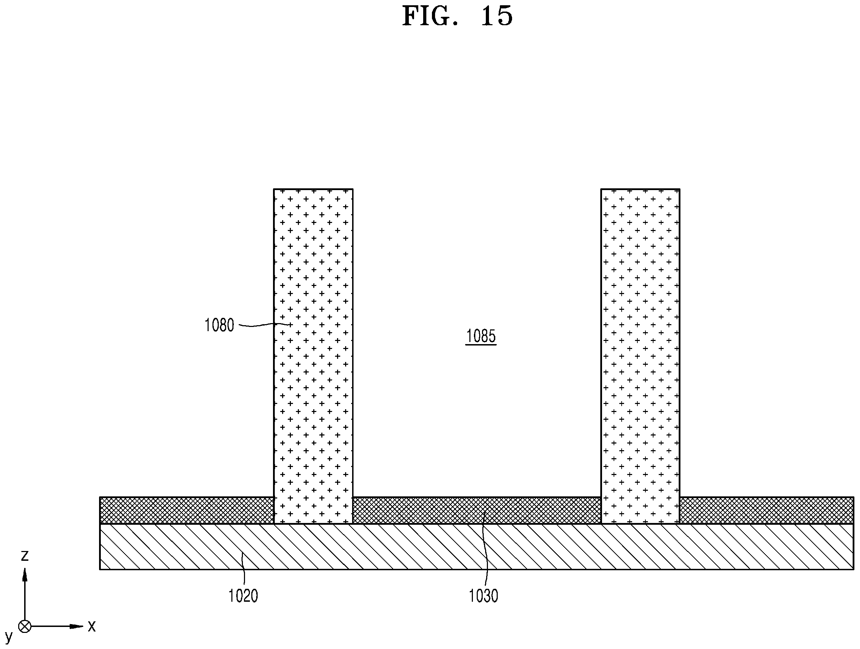

Referring to FIG. 15, a first interlayer 1030 may be deposited on the lower electrode 1020. The first interlayer 1030 may include indium oxide or indium nitride. The first interlayer 1030 may be deposited using an ALD process. The first interlayer 1030 may include a thickness in the range of about 1 nm to about 5 nm.

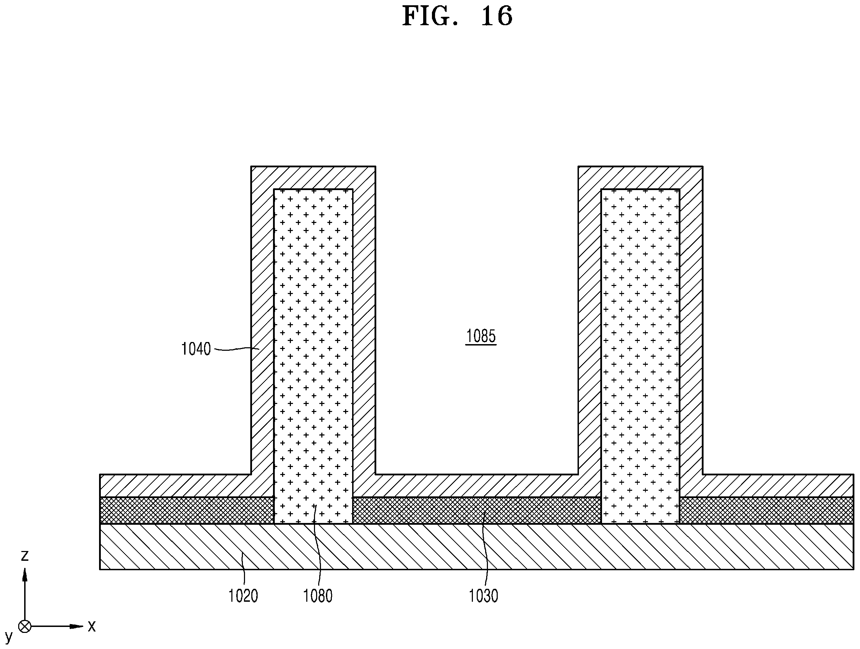

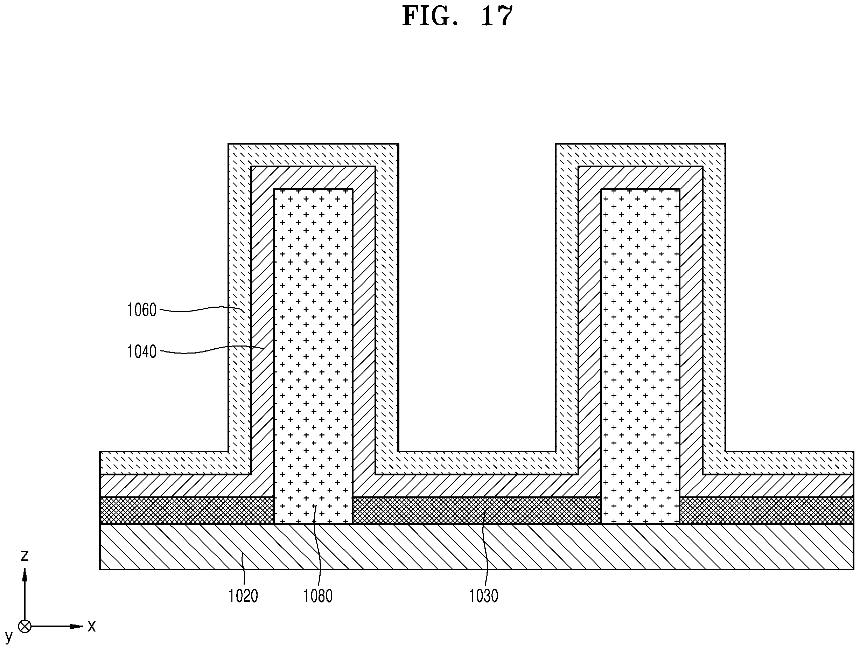

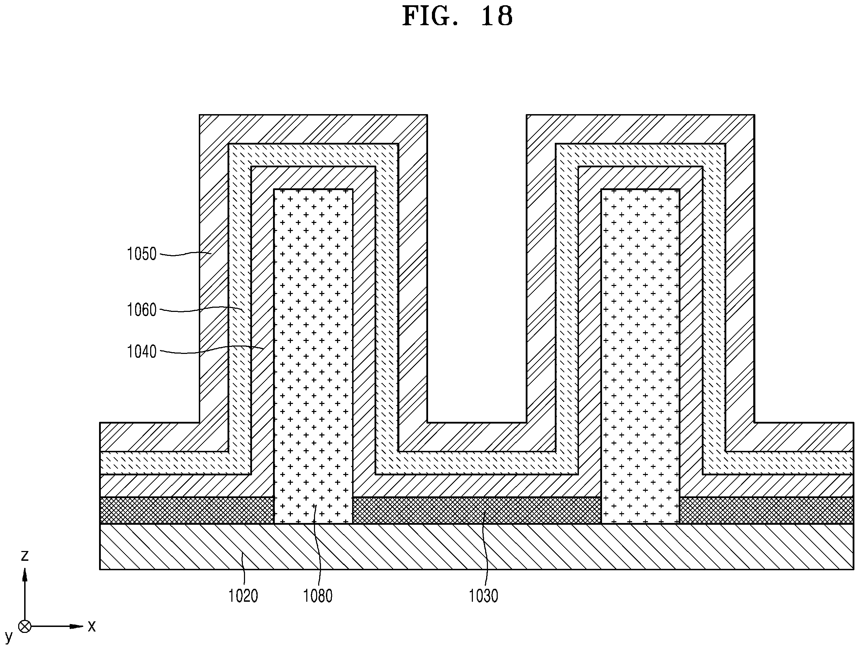

Referring to FIG. 16, a channel 1040 including an oxide semiconductor may be deposited on the first interlayer 1030 and the mold insulating layer 1080. The channel 1040 may be deposited in an ALD method. The channel 1040 may have a U-shaped cross-section. Referring to FIG. 17, a gate insulating layer 1060 may be deposited on a channel 1040. Referring to FIG. 18, a gate electrode 1050 may be deposited on a gate insulating layer 1060.

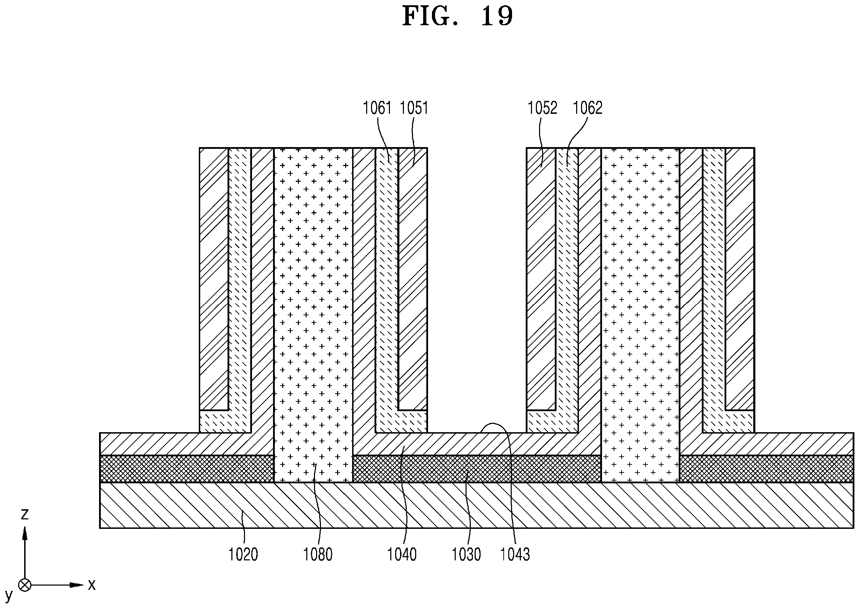

Referring to FIG. 19, anisotropic etching is performed on the gate electrode 1050 of a structure shown in FIG. 18, so that a bottom portion 1043 of the channel 1040 may be exposed. Accordingly, the gate electrode 1050 may be separated into a first gate electrode 1051 and a second gate electrode 1052, and the gate insulating layer 1060 may be separated into a first gate insulating layer 1061 and a second gate insulating layer 1062. In addition, the gate electrode 1050, the gate insulating layer 1060, and the channel 1040 may be etched on an upper portion of the mold insulating layer 1080 so that an upper surface of the mold insulating layer 1080 may be exposed. An upper surface level of the mold insulating layer 1080, upper surface levels of the first gate electrode 1051 and the second gate electrode 1052, and upper surface levels of the first gate insulating layer 1061 and the second gate insulating layer 1062 may coincide with each other.

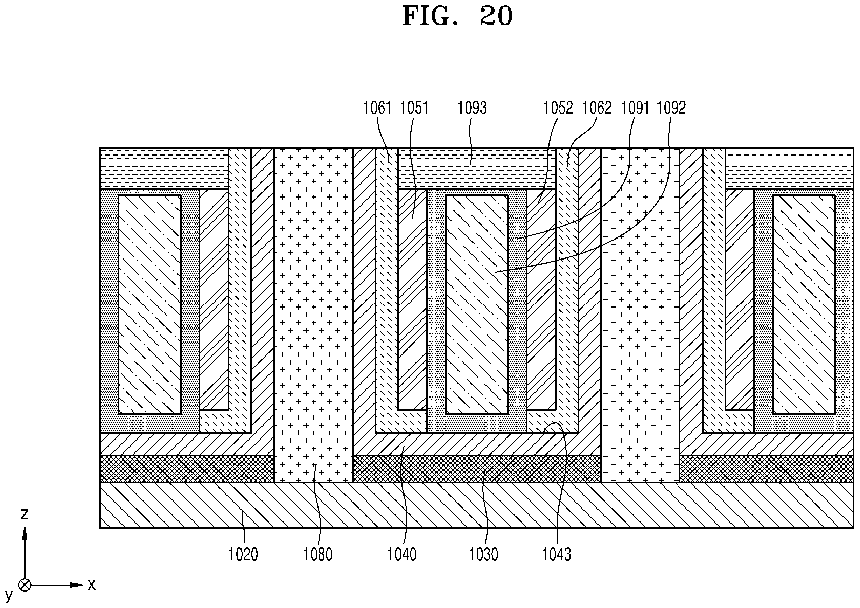

Referring to FIG. 20, when etching is performed on the first gate electrode 1051 and the second gate electrode 1052 once more, the upper surface levels of the first gate electrode 1051 and the second gate electrode 1052 may be lower than upper surface level of the mold insulating layer 1080.

Referring to FIG. 20, an insulating liner 1091 may be deposited from a surface of the bottom portion 1043 of the channel 1040 to the upper surface levels of the first gate electrode 1051 and/or the second gate electrode 1052. A buried insulating layer 1092 may be filled inside the insulating liner 1091. The insulating liner 1091 and the buried insulating layer 1092 may not be distinguished from each other. An upper insulating layer 1093 may be deposited on upper surfaces of the first gate electrode 1051 and/or the second gate electrode 1052 and an upper surface of the insulating liner 1091. A surface level of the upper insulating layer 1093 may coincide with the upper surface level of the mold insulating layer 1080, the upper surface level of the channel 1040, and the upper surface levels of the first gate insulating layer 1061 and the second gate insulating layer 1062.

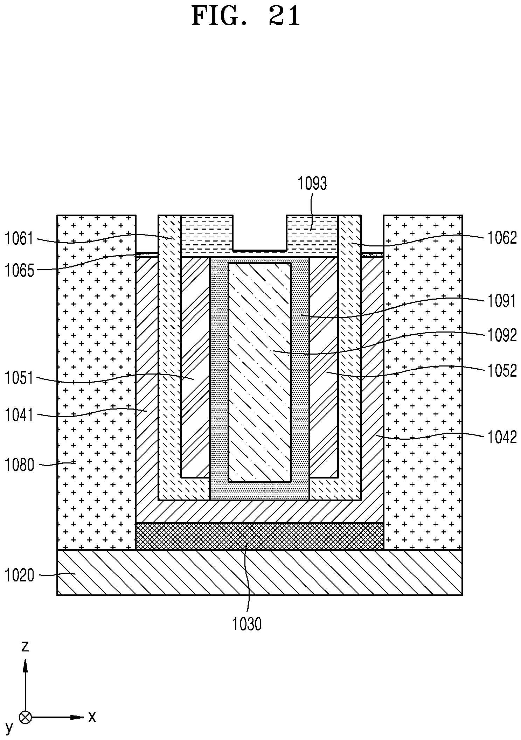

FIG. 21 illustrates only a portion corresponding to one pixel in FIG. 20 for convenience. Referring to FIG. 21, upper portions of a first channel 1041 and a second channel 1042 may be partially etched, and a second interlayer 1065 may be deposited on the upper portions of the first channel 1041 and the second channel 1042. The second interlayer 1065 may use an ALD process. The second interlayer 1065 may have a thickness in the range of about 1 nm to about 3 nm. When the upper portions of the first channel 1041 and the second channel 1042 are partially etched, the upper portion of the upper insulating layer 1093 may be partially etched.

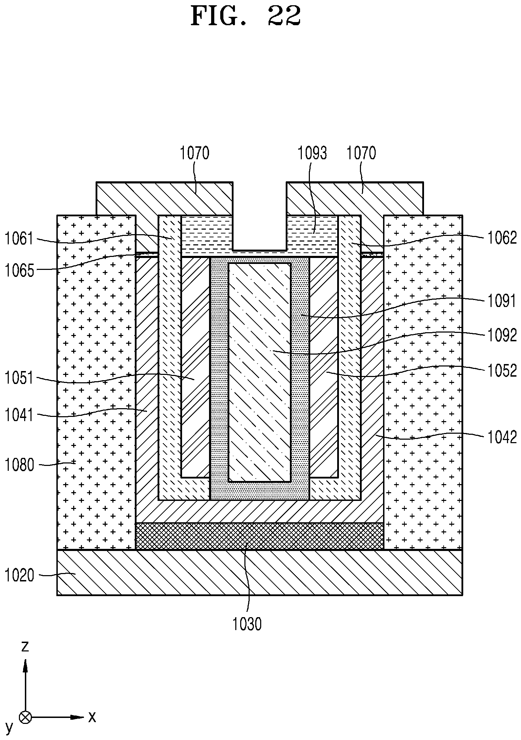

Referring to FIG. 22, an upper electrode 1070 may be deposited on a structure shown in FIG. 21. After depositing the upper electrode 1070, a central portion of the upper electrode 1070 and the upper portion of the upper insulating layer 1093 may be partially etched to separate the upper electrode 1070.

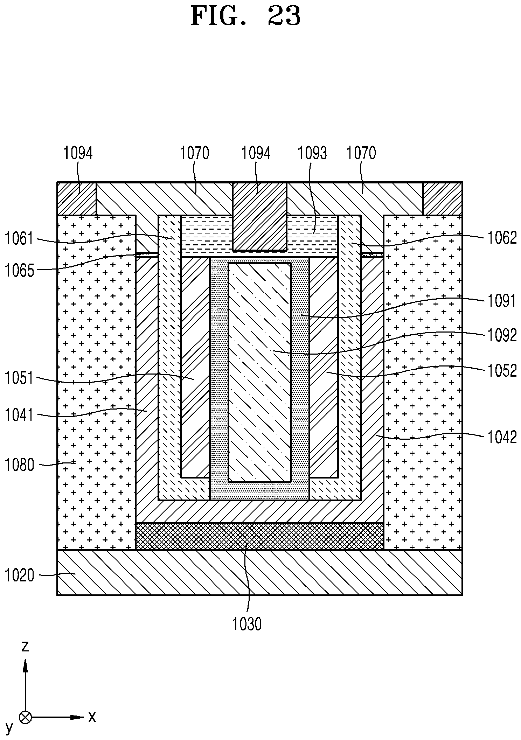

Referring to FIG. 23, an upper electrode insulating layer 1094 may be deposited between the upper electrodes 1070 and on a part of the upper portion of the upper insulating layer 1093. An upper surface level of the upper electrode insulating layer 1094 and a surface level of the upper electrode 1070 may coincide with each other.

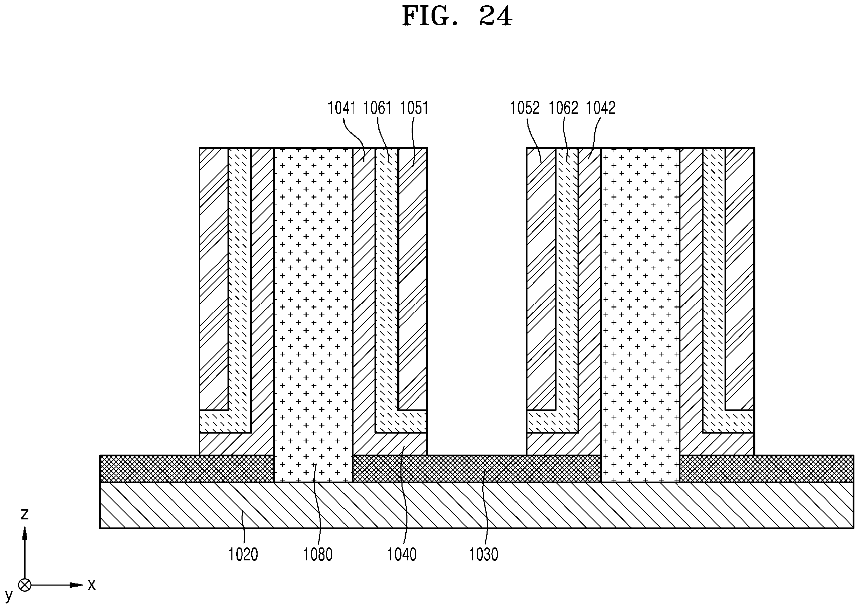

FIG. 24 is a diagram illustrating a method of manufacturing a semiconductor device illustrated in FIG. 10. Hereinafter, descriptions redundant with those of FIG. 19 are omitted and differences are mainly described.

Referring to FIG. 24, the gate electrode 1050, the gate insulating layer 1060, and the channel 1040 may be etched on a bottom portion of an opening so that a surface of the first interlayer 1030 may be partially exposed. Thus, the channel 1040 may be separated into the first channel 1041 and the second channel 1042, the gate insulating layer 1060 may be separated into the first gate insulating layer 1061 and the second gate insulating layer 1062, and the gate electrode 1050 may be separated into the first gate electrode 1051 and the second gate electrode 1052.

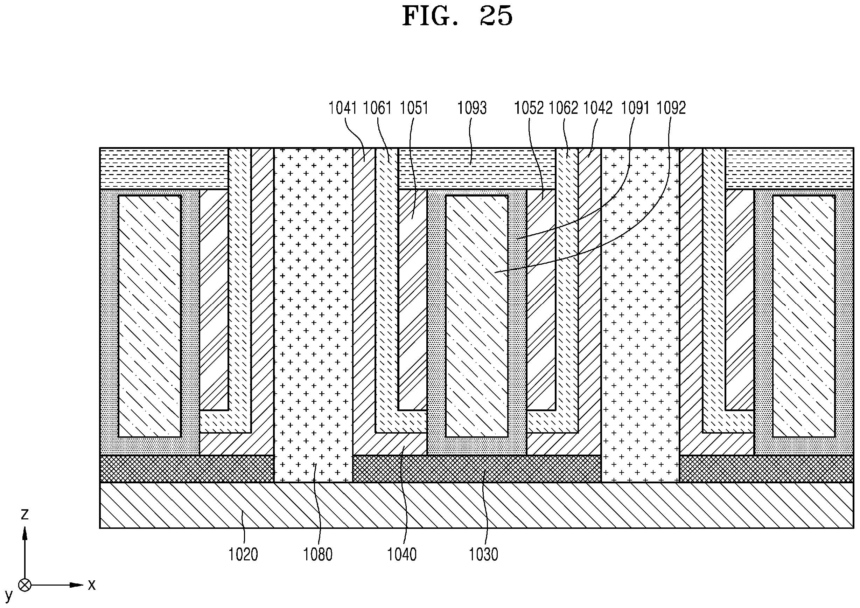

Referring to FIG. 25, the insulating liner 1091 may be deposited from an upper surface of the first interlayer 1030 to upper surface levels of the first gate electrode 1051 and/or the second gate electrode 1052.

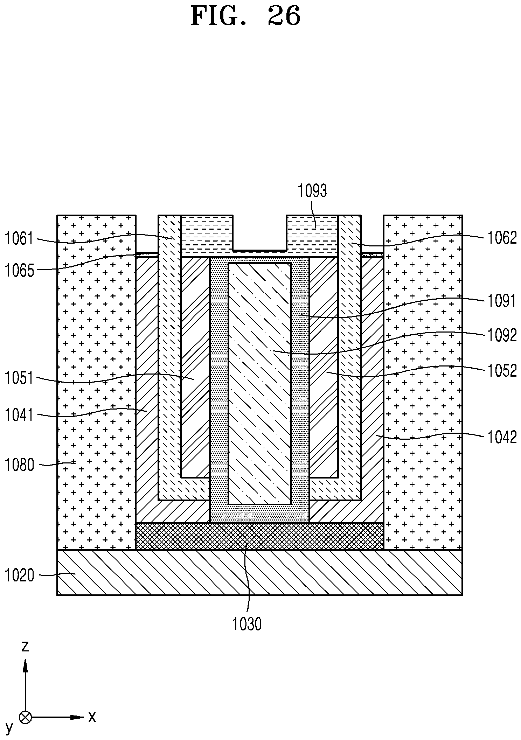

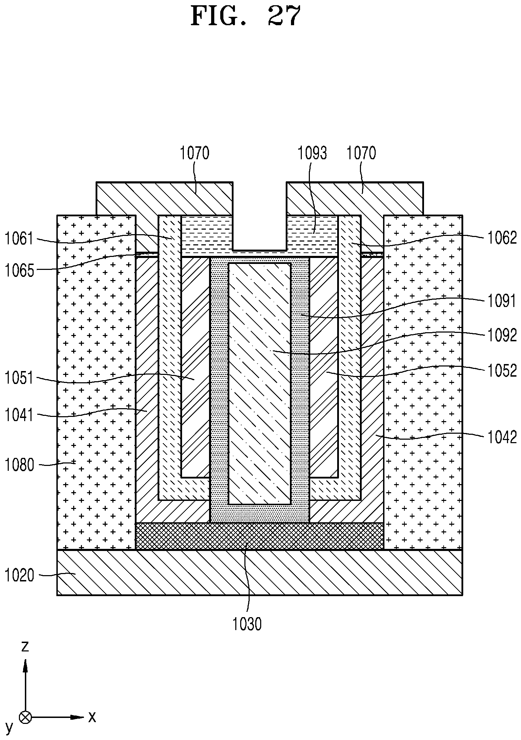

Referring to FIG. 26, similar to FIG. 21, upper portions of the first channel 1041 and the second channel 1042 may be partially etched, and the first interlayer 1065 may be deposited on the upper portions of the first channel 1041 and the second channel 1042. In addition, as illustrated in FIG. 27, the upper electrode 1070 may be deposited on a structure illustrated in FIG. 26, and a central portion of the upper electrode 1070 and an upper portion of the upper insulating layer 1093 may be partially etched.

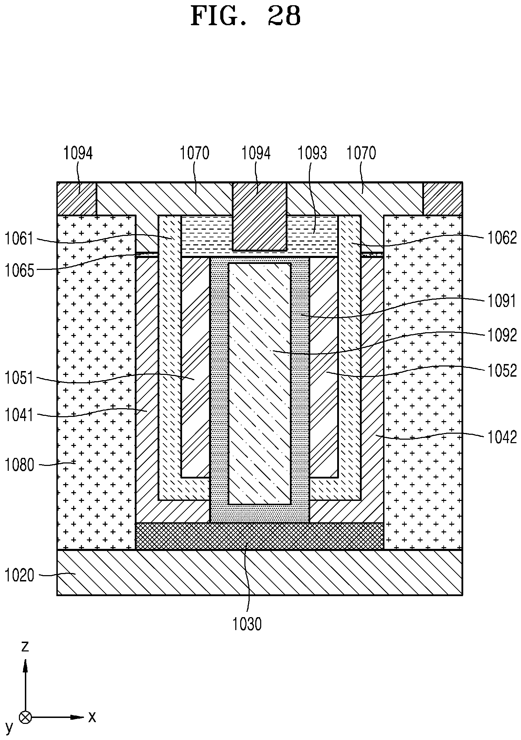

Referring to FIG. 28, similar to FIG. 23, the upper electrode insulating layer 1094 may be deposited between the upper electrodes 1070 and on a part of the upper portion of the upper insulating layer 1093. An upper surface level of the upper electrode insulating layer 1094 and a surface level of the upper electrode 1070 may coincide with each other.

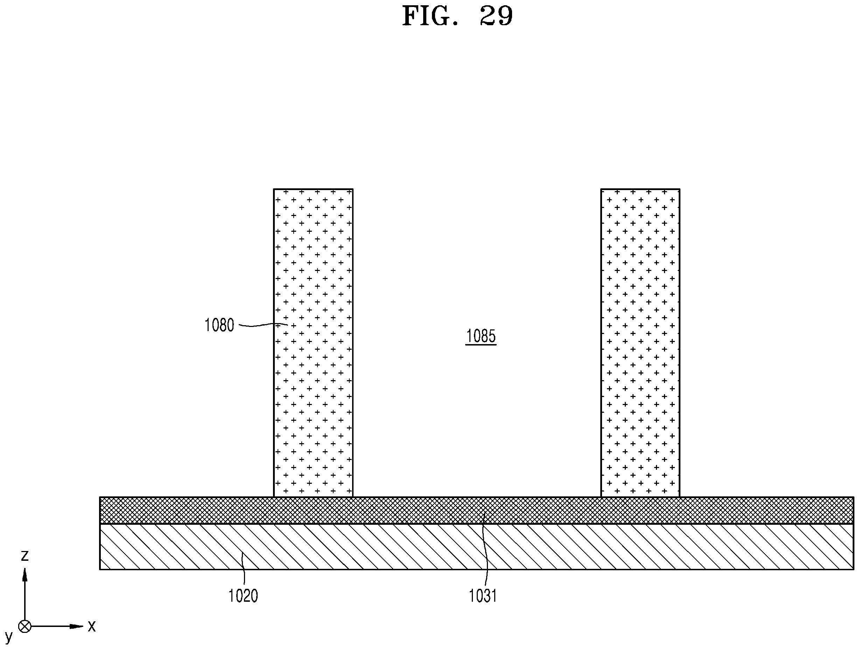

In FIG. 29, compared with FIG. 15, only a first interlayer 1031 is changed. The first interlayer 1031 may be deposited on the entire surface of the lower electrode 1020. The first interlayer 1031 may be formed with a selectivity of an In precursor. The lower electrode 1020 may be formed as a bit line, and the first interlayer 1031 may be formed and patterned on the lower electrode 1020 of the bit line.

The semiconductor device according to an embodiment may be applied to, for example, a transistor, a field effect transistor (FET), a semiconductor memory device, a logic device, an image sensor, etc. The logic device is in charge of computation and control, and the memory device is in charge of storing information. The logic device may be applied to a micro component, an analog IC, a logical IC, etc. The analog IC may include a power semiconductor, an image sensor, a touch controller, etc. The logical IC may include a display driver IC (DDI), a T-CON, a media IC, an application processor (AP), a vehicle semiconductor, etc. The memory device may include a DRAM, an SRAM, a NAND memory, etc.

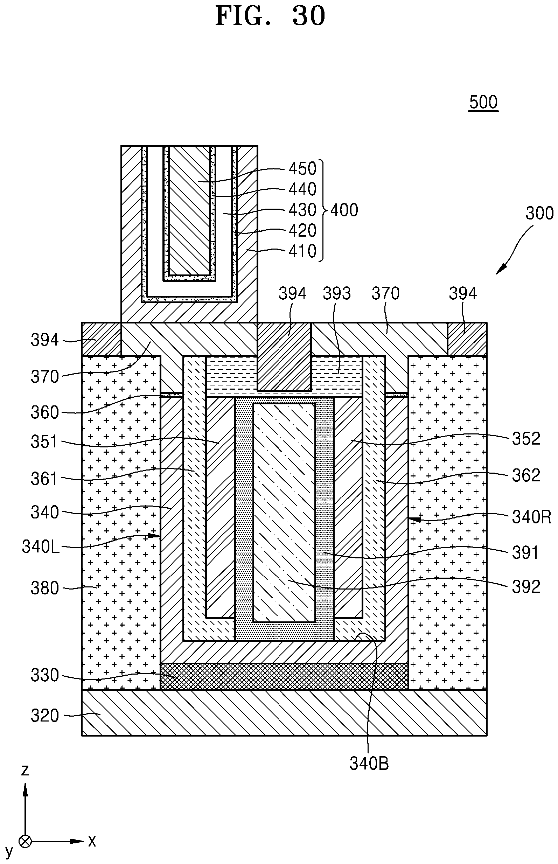

FIG. 30 illustrates an example in which the semiconductor device 300 according to an embodiment is applied to a DRAM. The semiconductor device 300 is the same as that described with reference to FIG. 8, and thus, a detailed description thereof is omitted for simplicity of description.

Referring to FIG. 30, a memory device 500 may include the semiconductor device 300 and a capacitor 400 connected to the upper electrode 370 of the semiconductor device 300.

The capacitor 400 may include a first electrode 410, a dielectric layer 430, and a second electrode 450. The dielectric layer 430 may include at least one of, for example, HfO₂, ZrO₂, CeO₂, LazOs, TazOs, and TiO₂. A lower interfacial layer 420 may be further provided between the first electrode 410 and the dielectric layer 430. The lower interfacial layer 420 may include a material expressed in MM'ON, M'O, or M'ON, M may include any one of Be, B, Na, Mg, Al, Si, K, Ca, Sc, Ti, V, Cr, Mn, Fe, Co, Ni, Cu, Zn, Ga, Ge, Rb, Sr, Y, Zr, Nb, Mo, Tc, Ru, Rh, Pd, Ag, Cd, In, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, TI, Pb, Bi, Po, Fr, Ra, Ac, Th, Pa, and U, and M' may include any one of H, Li, Be, B, N, O, Na, Mg, Al, Si, P, S, K, Ca, Sc, Ti, V, Cr, Mn, Fe, Co, Ni, Cu, Zn, Ga, Ge, As, Se, Rb, Sr, Y, Zr, Nb, Mo, Tc, Ru, Rh, Pd, Ag, Cd, In, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, TI, Pb, Bi, Po, Fr, Ra, Ac, Th, Pa, and U. A leakage current reduction layer 440 may be further provided between the dielectric layer 430 and the second electrode 450. The leakage current reduction layer 440 may include, for example, an AlZrO layer. However, the leakage current reduction layer 440 is not limited thereto.

As described above, when the semiconductor device 300 according to an embodiment is applied to the memory device 500, even though the memory device 500 is miniaturized, the semiconductor device 300 may include the first interlayer 330 and the second interlayer 360, thereby reducing contact resistance and improving electrical characteristics.

In FIG. 30, the semiconductor devices 100A, 100B, 200, 300A, 300B, and 300C according to the embodiments may be applied instead of the semiconductor device 300.

A semiconductor device according to an embodiment has an ultra-small size and excellent electrical performance, and is therefore suitable for application to an integrated circuit (IC) device having a high integration.

The semiconductor device according to an embodiment may constitute a transistor constituting a digital circuit or an analog circuit. In some configurations, the semiconductor device may be used as a high voltage transistor or a low voltage transistor. For example, the semiconductor device in an embodiment may constitute a high voltage transistor that constitutes a peripheral circuit of a flash memory device and an electrically erasable and programmable read only memory (EEPROM) device, which are non-volatile memory devices operating at a high voltage. Alternatively, the semiconductor device according to an embodiment may constitute a transistor included in an IC chip for a liquid crystal display (LCD), an IC chip used in an LED display device or a micro LED display device.

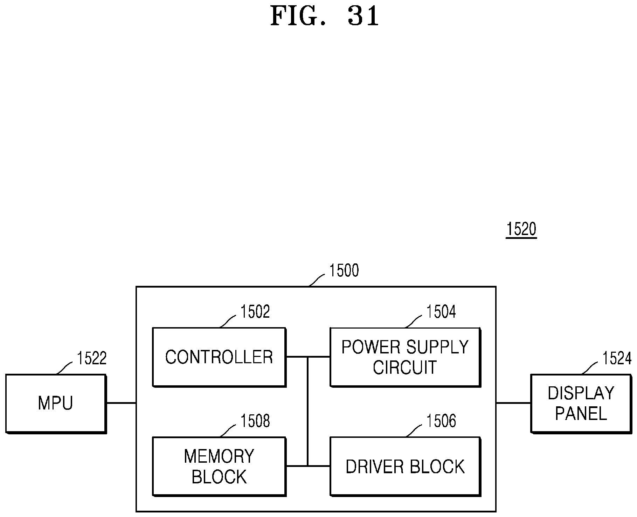

FIG. 31 is a schematic block diagram of a display driver IC (DDI) 1500 and a display device 1520 including the DDI 1500 according to an embodiment.

Referring to FIG. 31, the DDI 1500 may include a controller 1502, a power supply circuit 1504, a driver block 1506, and a memory block 1508. The controller 1502 receives and decodes a command applied from a main processing unit (MPU) 1522, and controls each of blocks of the DDI 1500 to implement an operation according to the command. The power supply circuit 1504 generates a driving voltage in response to the control of the controller 1502. The driver block 1506 drives a display panel 1524 by using the driving voltage generated by the power supply circuit 1504 in response to the control of the controller 1502. The display panel 1524 may be a LCD panel or a micro LED device. The memory block 1508 is a block that temporarily stores a command input to the controller 1502 or control signals output from the controller 1502, or stores necessary data, and may include a memory such as RAM and ROM. The power supply circuit 1504 and the driver block 1506 may include the semiconductor devices 100, 200, 300, 300A, 300B, and 300C according to the above-described embodiment.

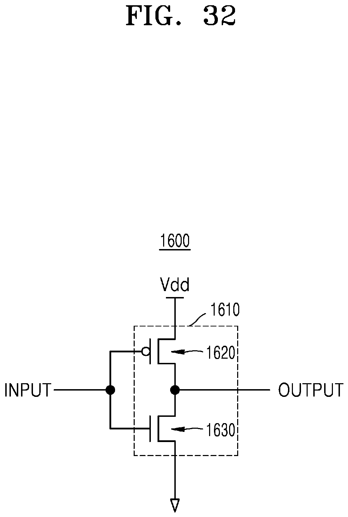

FIG. 32 is a circuit diagram of a CMOS inverter 1600 according to an embodiment.

The CMOS inverter 1600 includes a CMOS transistor 1610. The CMOS transistor 1610 includes a PMOS transistor 1620 and an NMOS transistor 1630 connected to each other between a power terminal Vdd and a ground terminal. The CMOS transistor 1610 may include the semiconductor devices 100, 200, 300, 300A, 300B, and 300C according to the above-described embodiment.

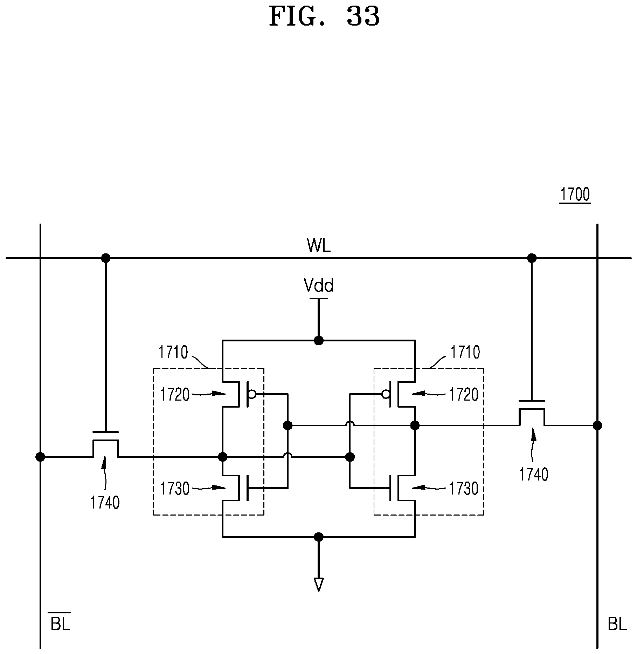

FIG. 33 is a circuit diagram of a CMOS SRAM device 1700 according to an embodiment.

The CMOS SRAM device 1700 includes a pair of driving transistors 1710. The pair of driving transistors 1710 each include a PMOS transistor 1720 and an NMOS transistor 1730 connected to each other between the power terminal Vdd and a ground terminal. The CMOS SRAM device 1700 may further include a pair of transfer transistors 1740. Sources of the transfer transistors 1740 are cross-connected to a common node of the PMOS transistor 1720 and the NMOS transistor 1730 constituting the driving transistors 1710. The power terminal Vdd is connected to a source of the PMOS transistor 1720, and the ground terminal is connected to a source of the NMOS transistor 1730. A word line WL may be connected to gates of the pair of transmission transistors 1740, and a bit line BL and an inverted bit line may be respectively connected to drains of the pair of transmission transistors 1740.

At least one of the driving transistor 1710 and the transmission transistor 1740 of the CMOS SRAM device 1700 may include the semiconductor devices 100, 200, 300, 300A, 300B, and 300C according to the above-described embodiment.

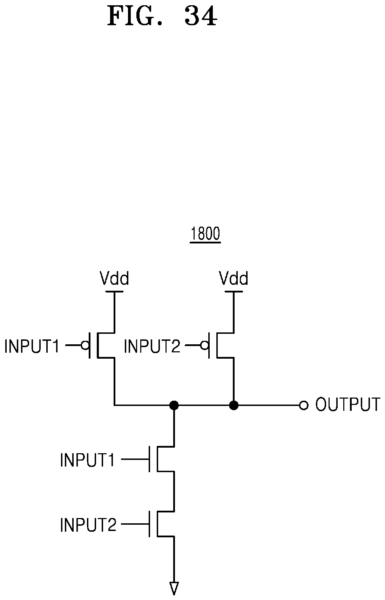

FIG. 34 is a circuit diagram of a CMOS NAND circuit 1800 according to an embodiment.

The CMOS NAND circuit 1800 includes a pair of CMOS transistors to which different input signals are transmitted. The CMOS NAND circuit 1800 may include the semiconductor devices 100, 200, 300, 300A, 300B, and 300C according to the above-described embodiment.

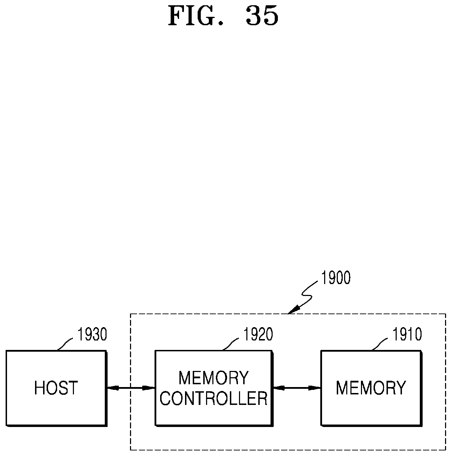

FIG. 35 is a block diagram illustrating an electronic system 1900 according to an embodiment.

The electronic system 1900 includes a memory 1910 and a memory controller 1920. The memory controller 1920 may control the memory 1910 to read data from the memory 1910 and/or write data to the memory 1910 in response to a request from a host 1930. At least one of the memory 1910 and the memory controller 1920 may include the semiconductor devices 100, 200, 300, 300A, 300B, and 300C according to the above-described embodiment.

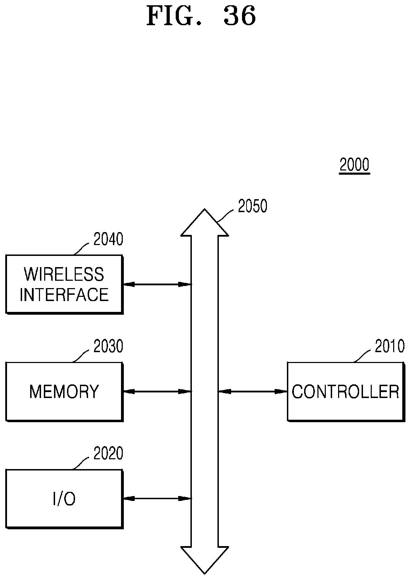

FIG. 36 is a block diagram of an electronic system 2000 according to an embodiment.

The electronic system 2000 may configure a wireless communication device, or a device capable of transmitting and/or receiving information under a wireless environment. The electronic system 2000 includes a controller 2010, an input/output device (I/O) 2020, a memory 2030, and a wireless interface 2040, which are interconnected through a bus 2050.

The controller 2010 may include at least one of a microprocessor, a digital signal processor, and a processing device similar thereto. The I/O device 2020 may include at least one of a keypad, a keyboard, and a display. The memory 2030 may be used to store a command executed by the controller 2010. For example, the memory 2030 may be used to store user data. The electronic system 2000 may use the wireless interface 2040 to transmit/receive data through a wireless communication network. The wireless interface 2040 may include an antenna and/or a wireless transceiver. The electronic system 2000 may include the semiconductor devices 100, 200, 300, 300A, 300B, and 300C according to the above-described embodiment with reference to FIGS. 1 to 26.

A semiconductor device according to an embodiment may exhibit good electrical performance with an ultra-small structure, may be therefore applied to an IC device, and may implement miniaturization, low power, and high performance.

The semiconductor device according to an embodiment may include a first interlayer between a lower electrode and a channel, and a second interlayer between an upper electrode and the channel, thereby reducing contact resistance.

As the size of the semiconductor device decreases and the contact area between an electrode and the channel decreases, the contact resistance increases. The semiconductor device according to an embodiment may reduce the contact resistance by using the first interlayer and the second interlayer including different materials.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a lower electrode;
a channel on the lower electrode, the channel comprising an oxide semiconductor;
an upper electrode on the channel, the upper electrode comprising tungsten or molybdenum;
a first interlayer between the lower electrode and the channel; and
a second interlayer between the channel and the upper electrode,
wherein the channel has a vertical channel structure extending in a vertical direction from the lower electrode to the upper electrode,
the first interlayer and the second interlayer comprise different materials from each other,
the first interlayer comprises indium oxide or indium nitride, and
the second interlayer comprises a material having an oxide forming energy greater than an oxide forming energy of the upper electrode, and the oxide forming energy of the second interlayer is in a range of -2.5 eV/atom to 0.5 eV/atom.

2. The semiconductor device of claim 1, wherein the second interlayer includes a material having a work function in a range of 4.6 eV to 6.0 eV.

3. The semiconductor device of claim 1 or 2, wherein a difference between the oxide forming energy of the second interlayer and the oxide forming energy of the upper electrode is in a range of 0.5 eV/atom to 3.58 eV/atom.

4. The semiconductor device of any preceding claim, wherein the second interlayer includes at least one of Ni, Co, Rh, Pd, Pt, Re, Ru, and Cu.

5. The semiconductor device of any preceding claim, wherein the channel is an oxide including at least one of In, Zn, Ga, Sn, Hf, and Ti.

6. The semiconductor device of any preceding claim, further comprising: a bonding layer including TiN between the second interlayer and the upper electrode.

7. The semiconductor device of any preceding claim, wherein the second interlayer extends from a bonding surface between the channel and the upper electrode to a side surface of the upper electrode.

8. The semiconductor device of any preceding claim, wherein the first interlayer has a thickness in a range of 1 nm to 5 nm.

9. The semiconductor device of any preceding claim, wherein the second interlayer has a thickness in a range of 1 nm to 3 nm.

10. The semiconductor device of any preceding claim, wherein a thickness of the second interlayer is less than a thickness of the first interlayer.

11. The semiconductor device of any preceding claim, further comprising: a metal oxide layer between the lower electrode and the first interlayer.

12. The semiconductor device of any preceding claim, wherein the channel has a U-shaped cross section.

13. The semiconductor device of any preceding claim, wherein the channel includes a first channel having an L-shaped cross-section and a second channel disposed symmetrically to the first channel with respect to a vertical direction of the semiconductor device.

14. A method of manufacturing a semiconductor device, the method comprising:
depositing a lower electrode on a substrate;
depositing a first interlayer on the lower electrode;
depositing a channel comprising an oxide semiconductor on the first interlayer;
depositing a gate insulating layer on the channel;
depositing a gate electrode on the gate insulating layer;
depositing a second interlayer on an upper surface of the channel; and
depositing an upper electrode on the second interlayer,
wherein the first interlayer and the second interlayer comprise different materials from each other,
the first interlayer comprises indium oxide or indium nitride, and
the second interlayer comprises a material having an oxide forming energy greater than an oxide forming energy of the upper electrode, and the oxide forming energy of the second interlayer is in a range of -2.5 eV/atom to 0.5 eV/atom.

15. The method of claim 17, wherein the first interlayer, the channel, and the second interlayer are formed by an atomic layer deposition method.
